# EUROPEAN PATENT APPLICATION

(11) **EP 4 645 683 A1**
(43) Date of publication of application: **05.11.2025**
(21) Application number: 24918928.3
(22) Date of filing: 22.08.2024
(51) Int. Cl.: H02S 40/32, H02M 7/00, H01R 12/71, H01R 13/62

(54) **MICROINVERTER**

(30) Priority: 17.01.2024 KR 20240007260
(71) Applicant: Hanwha Solutions Corporation, Jung-gu Seoul 04541 (KR)
(72) Inventor: KIM, Joongtae, Seoul 04541 (KR); YUN, Juhwan, Seoul 04541 (KR); KIM, Jungguen, Seoul 04541 (KR); PARK, Taesung, Seoul 04541 (KR)
(74) Representative: Mooser, Sebastian Thomas
(86) International application number: PCT/KR2024/012506
(87) International publication number: WO 2025/154894

(57) **Abstract**

The present disclosure relates to a microinverter. The microinverter includes a case having an internal space, a circuit board disposed inside the case, a first connector supported by the case and connected directly to one side of the circuit board, and a second connector supported by the case and connected directly to the other side of the circuit board.

## Description

### Technical Field

The present disclosure relates to a microinverter.

### Background Art

Inverters are devices that convert a DC current into an AC current and are used in various industrial application fields that use electronic devices such as electric motor drives, uninterruptible power supplies (UPSs), and active power filters as well as fields of renewable energy conversion systems including solar power generators, hybrid vehicles, and the like.

Recently, microinverters are being applied in the solar power generation inverter market, mainly in the US market. Microinverter are distributed systems that convert a DC current into an AC current in a module unit by installing each mall inverter on individual solar cell modules.

A microinverter includes a printed circuit board array (PCBA), which converts a current, therein, and the PCBA is equipped with a DC connector connected to a solar cell module and an AC connector connected to an AC cable for distributing generated power. However, microinverters have limitations in the mounting positions and assembly stability of connectors due to a size of a miniaturized device and have a problem of limited freedom in internal design.

### Disclosure

### Technical Problem

The present disclosure is directed to providing a microinverter in which mounting positions of a DC connector and an AC connector which are connected to an inverter are each independently positioned, thereby facilitating design change and device miniaturization and also improving assembly stability.

### Technical Solution

According to an aspect of the present disclosure, there is provided a microinverter including a case having an internal space, a circuit board disposed inside the case; a first connector which is supported by the case and of which a first terminal is connected directly to one side of the circuit board, and a second connector which is supported by the case to be spaced apart from the first connector and of which a second terminal is connected directly to the other side of the circuit board.

### Advantageous Effects

In a microinverter according to an embodiment of the present disclosure, by separately connecting each of a first connector and a second connector to a circuit board, an internal structure of an inverter may be simplified, thereby improving a degree of freedom in structural design of the inverter and obtaining an advantage in miniaturizing a device.

In addition, in an microinverter, when a first connector and a second connector are connected directly to a circuit board, a sturdy assembly structure may be formed to stably manage power conversion performance.

### Description of Drawings

FIG. 1 is a view illustrating a microinverter according to an embodiment of the present disclosure.
FIG. 2 is an exploded perspective view of the microinverter of FIG. 1.
FIG. 3 is a perspective view illustrating a first connector of FIG. 1.
FIG. 4 is an exploded perspective view of a portion of the first connector of FIG. 3.
FIG. 5 is an enlarged view illustrating a part of FIG. 1 to which the first connector is assembled.
FIG. 6 is a partial cross-sectional view of the microinverter viewed in an A-A' direction of FIG. 5.
FIG. 7 is a perspective view illustrating a second connector of FIG. 1.
FIG. 8 is an enlarged view illustrating a part of FIG. 1 to which the second connector is assembled.
FIG. 9 is a partial cross-sectional view of the microinverter viewed in a B-B' direction of FIG. 8.

### Best Mode

An aspect of the present disclosure provides a microinverter including a case having an internal space, a circuit board disposed inside the case; a first connector which is supported by the case and of which a first terminal is connected directly to one side of the circuit board, and a second connector which is supported by the case to be spaced apart from the first connector and of which a second terminal is connected directly to the other side of the circuit board.

In addition, the first terminal may include a first terminal tab having one end portion connected to a cable, a connection tube disposed between the other end portion of the first terminal tab and the circuit board, and a fixing member which passes through the connection tube to connect the first terminal tab to the circuit board.

In addition, the first connector may include guide pieces configured to support opposite side surfaces of the first terminal tab, a support pin which passes through the first terminal tab, and a pin insert groove which supports one surface of the first terminal tab and accommodates the support pin.

In addition, the case may include a first mount portion in which the first connector is mounted and which includes a first mount groove and a first mount protrusion, and the first connector may include a first housing including a first connector protrusion inserted into the first mount groove and a first connector groove into which the first mount protrusion is inserted.

In addition, the first housing may further include a first insert groove into which the first fitting piece of the case is inserted.

In addition, the second terminal may include a second terminal tab having an end portion inserted into a connection hole of the circuit board.

In addition, the case may include a second mount portion in which the second connector is mounted and which includes a second mount groove and a second mount protrusion, and the second connector may include a second housing including a second connector protrusion inserted into the second mount groove and a second connector groove into which the second mount protrusion is inserted.

In addition, the second housing may further include a second insert groove into which a second fitting piece of the case is inserted.

In addition, the case may include a support block which protrudes inward and supports the first connector and the second connector.

### Mode of Invention

Since the disclosure can apply various transformations and have various embodiments, specific embodiments will be illustrated in the drawings and described in detail in the detailed description. The effects and features of the present disclosure and methods of accomplishing the same will become apparent from the following description of the embodiments in detail, taken in conjunction with the accompanying drawings. The present disclosure may, however, be embodied in many different forms and should not be construed as limited to the embodiments set forth herein.

Hereinafter, embodiments of the present disclosure will be described in detail with reference to the accompanying drawings, wherein like reference numerals refer to the same or corresponding components throughout the drawings, and a redundant description thereof will be omitted.

In the following embodiments, the terms first, second, and the like do not have limited meaning but are used for the purpose of distinguishing one component from another component.

In the following embodiments, the expressions used in the singular such as "a," "an," and "the" are intended to include the plural forms as well, unless the context clearly indicates otherwise.

In the following embodiments, it will be understood that the terms such as "including," "comprising," and "having" specify the presence of stated features or components, but do not preclude the presence or addition of one or more other features or components.

In the following embodiments, when an area, a component, or the like is positioned on or above another part, the present disclosure includes not only a case in which the area, the component, or the like is positioned directly above the other part, but also a case in which other areas, other components, or the like may be positioned therebetween.

In the drawings, components may be exaggerated or reduced in size for convenience of description. For example, the sizes and thicknesses of the respective components shown in the drawings are arbitrarily shown for convenience of description, and thus one or more embodiments are not necessarily limited thereto.

In the following embodiments, it will be understood that when an area, a component, or the like is referred to as being connected to another component, it can be directly connected to the other component or intervening components may also be present.

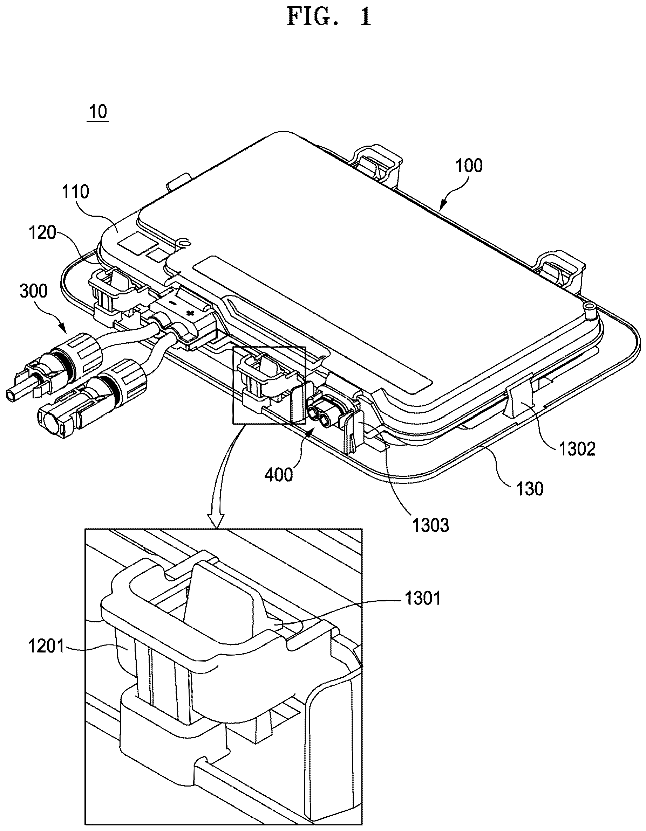

FIG. 1 is a view illustrating a microinverter 10 according to an embodiment of the present disclosure.

Referring to FIG. 1, in the microinverter 10, a first connector 300 and a second connector 400 may be formed to be connected to a case 100 that stores a circuit board therein.

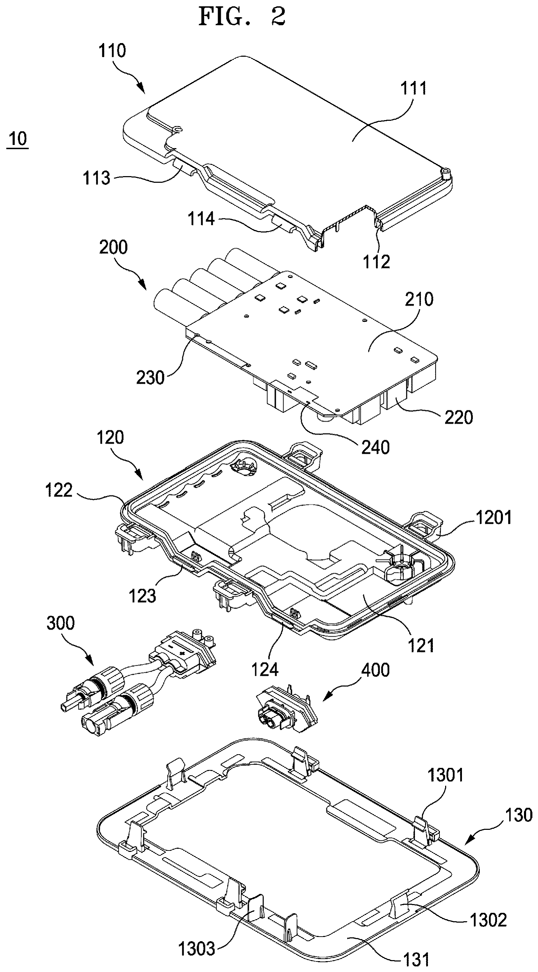

The case 100 may have an internal space. The case 100 may form an exterior of the microinverter 10 and may accommodate a circuit board 200 therein (see FIG. 2). The case 100 may fix a position of the circuit board. For this purpose, the internal shape of the case 100 may correspond to a shape of the circuit board.

The case 100 may protect the circuit board 200 disposed therein. For example, in consideration of the stable operation of the microinverter 10 and the influence of the surrounding environment, the case 100 may have functions of heat resistance, moisture resistance, water resistance, electrical insulation, cold resistance, oil resistance, impact resistance, and waterproof.

The case 100 may include an upper case 110, a lower case 120, and a support bracket 130. The case 100 may be formed by assembling the upper case 110, the lower case 120, and the support bracket 130.

The upper case 110 and the lower case 120 may be assembled to form a space therein. The circuit board 200 may be accommodated in an internal space of the upper case 110 and the lower case 120.

The upper case 110 and the lower case 120 may include a connection position for the first connector 300 and the second connector 400. The first connector 300 and the second connector 400 may be interposed between the upper case 110 and the lower case 120. As the upper case 110 and the lower case 120 are assembled, a position at which the first connector 300 is connected and a position at which the second connector 400 is connected may be set.

As an optional embodiment, the case 100 may further include a buckle 1201.

The buckle 1201 may be provided at one side of the case 100 and connected to the support bracket 130. The buckle 1201 may be fastened to a first hook 1301 of the support bracket 130.

The support bracket 130 may be disposed below the lower case 120. The support bracket 130 may support the lower case 120. The support bracket 130 may be connected to the upper case 110 or the lower case 120.

According to an embodiment, the support bracket 130 may be connected to the lower case 120 in a snap-fit manner. The snap-fit manner is a method of fastening two parts without a separate connection member because fastening is made by a hook being caught in a recessed portion. For example, the support bracket 130 may include the first hook 1301 and a second hook 1302 which are connected to the upper case 110 or the lower case 120.

The first hook 1301 may be connected to the buckle 1201. The first hook 1301 may be fitted into and fastened to the buckle 1201.

Optionally, the support bracket 130 may include an auxiliary buckle at a position adjacent to the first hook 1301. The buckle 1201 may include an auxiliary hook, which may be fastened to the auxiliary buckle, at one side thereof. Thus, when the first hook 1301 is connected to the buckle 1201 from below to above, since the auxiliary hook is connected to the auxiliary buckle from above to below, a stable connection may be made between the support bracket 130 and the lower case 120.

The second hook 1302 may have a structure in contact with one side of the upper case 110 or the lower case 120. At least a portion of the second hook 1302 may have elasticity. The second hook 1302 may fix the lower case 120 through force fitting.

The support bracket 130 may further include an alignment portion 1303.

The alignment portion 1303 may be positioned adjacent to the second connector 400 connected to the case 100. According to an embodiment, the alignment portion 1303 may be provided as guide walls that protrude from an upper surface of the support bracket 130 and are disposed in parallel to each other at both sides of the second connector 400. The alignment portion 1303 may align and support a position of a plug connected to the second connector 400.

FIG. 2 is an exploded perspective view of the microinverter 10 of FIG. 1.

Referring to FIG. 2, the microinverter 10 may include the case 100, the circuit board 200, the first connector 300, and the second connector 400.

According to an embodiment, the case 100 may include the upper case 110, the lower case 120, and the support bracket 130.

The upper case 110 may include a cover 111, a joint groove 112, a first fitting piece 113, and a second fitting piece 114.

The cover 111 may be provided in a plate shape covering an upper portion of the circuit board 200. The cover 111 may correspond to a shape of the upper portion of the circuit board 200. A lower surface of the cover 111 may be in contact with the upper portion of the circuit board 200 to fix a position of the circuit board 200.

The joint groove 112 may be formed in the lower surface of the cover 111. According to an embodiment, the joint groove 112 may be formed along a perimeter of the lower surface of the cover 111. The joint groove 112 may be provided to be connectable to the lower case 120. A portion of the lower case 120 may be fitted into the joint groove 112.

The first fitting piece 113 may be provided at one side of the cover 111 and may be in contact with the first connector 300 connected to the case 100. The first fitting piece 113 may be positioned adjacent to a position at which the first connector 300 is connected.

For example, the first fitting piece 113 may be provided as a protrusion protruding from one side surface of the upper case 110 toward an upper surface of the first connector 300. The first fitting piece 113 may be fastened to one side of the upper surface of the first connector 300.

The second fitting piece 114 may be provided at the other side of the cover 111 and may be in contact with the second connector 400 connected to the case 100. The second fitting piece 114 may be positioned adjacent to a position at which the second connector 400 is connected.

For example, the second fitting piece 114 may be provided as a protrusion protruding from the other side surface of the upper case 110 toward an upper surface of the second connector 400. The second fitting piece 114 may be fastened to one side of the upper surface of the second connector 400.

The lower case 120 may include a base 121, a base protrusion 122, a third fitting piece 123, a fourth fitting piece 124, and the buckle 1201.

The base 121portion may support the circuit board 200. The base 121 may be provided in a plate shape that surrounds a lower surface of the circuit board 200. The base 121 may correspond to a shape of the lower surface of the circuit board 200. The circuit board 200 may be seated on an upper surface of the base 121. The upper surface of the base 121 may be in contact with a lower portion of the circuit board 200 to fix a position of the circuit board 200.

The base protrusion 122 may be formed on the upper surface of the base 121. According to an embodiment, the base protrusion 122 may be formed along a perimeter of the upper surface of the base 121. The base protrusion 122 may be provided to be connectable to the upper case 110. The base protrusion 122 may be inserted into a portion of the upper case 110.

The third fitting piece 123 may be provided at one side of the base 121 and may be in contact with the first connector 300 connected to the case 100. The third fitting piece 123 may be disposed adjacent to a position at which the first connector 300 is connected.

For example, the third fitting piece 123 may be provided as a protrusion protruding from one side of the lower case 120 toward a lower surface of the first connector 300. The third fitting piece 123 may be fastened to one side of the lower surface of the first connector 300.

The fourth fitting piece 124 may be provided at the other side of the base 121 and may be in contact with the second connector 400 connected to the case 100. The fourth fitting piece 124 may be positioned adjacent to a position at which the second connector 400 is connected.

For example, the fourth fitting piece 124 may be provided as a protrusion protruding from the other side of the lower case 120 toward a lower surface of the second connector 400. The fourth fitting piece 124 may be fastened to one side of the lower surface of the second connector 400.

The buckle 1201 may be formed to protrude outward from a side surface of the lower case 120. The buckle 1201 may be connected to the first hook 1301 of the support bracket 130. The buckle 1201 may be formed in a ring or groove shape by which the first hook 1301 is caught.

The circuit board 200 may be provided to convert DC power into AC power. The first connector 300 may be connected to one side of the circuit board 200, and the second connector 400 may be connected to the other side of the circuit board 200.

The circuit board 200 may be disposed between the upper case 110 and the lower case 120. The circuit board 200 may be accommodated in an internal space formed by assembling the upper case 110 and the lower case 120. The circuit board 200 may be supported by the upper case 110 and the lower case 120 so that a position thereof may be fixed.

The circuit board 200 may be formed by arranging preset circuit patterns and circuit components on one surface or opposite surfaces. For example, the circuit board 200 may be provided as a typical printed circuit board assembly (PCBA). Hereinafter, descriptions will be provided based on a case in which the circuit board 200 is used singly, but as needed, the circuit board 200 may be used by integrating a plurality of layers.

The circuit board 200 may include a substrate unit 210, a circuit unit 220, a first connection hole 230, and a second connection hole 240.

The substrate unit 210 may have a plate shape and may have a circuit pattern printed on one surface opposite surfaces or have a surface on which circuit components are disposed. The circuit unit 220 may be disposed on the substrate unit 210.

The circuit unit 220 may include a circuit for converting DC power into AC power. The circuit unit 220 may include components such as a circuit pattern printed with copper, an integrated circuit (IC), a capacitor, and a transformer which are disposed on the substrate unit 210. For example, the circuit unit 220 may include a voltage boosting circuit for boosting an input DC voltage and a conversion circuit for converting DC power into AC power and may include respective circuit components.

The first connection hole 230 may be formed in one side of the substrate unit 210, and the second connection hole 240 may be formed in the other side thereof. The first connection hole 230 and the second connection hole 240 may each be formed in a hole shape passing through the substrate unit 210. The first connection hole 230 may define a position at which the first connector 300 is connected to the substrate unit 210, and the second connection hole 240 may define a position at which the second connector 400 is connected to the substrate unit 210.

The first connector 300 and the second connector 400 may be provided to connect the microinverter 10 to the outside. The first connector 300 and the second connector 400 may be connected to an external power source and power system using a cable or other connectors.

According to an embodiment, the first connector 300 may be provided as a DC connector, and the second connector 400 may be provided as an AC connector.

The first connector 300 may be connected to a solar cell module (not shown). The solar cell module is a device that converts light energy into electrical energy through a photovoltaic effect. DC power generated by a solar module may be input to the first connector 300. The first connector 300 may transmit input DC power to the circuit board 200.

The second connector 400 may be connected to a power system (not shown). The second connector 400 may output AC power converted by the circuit board 200. The second connector 400 may transmit AC power to a user through an AC output cable.

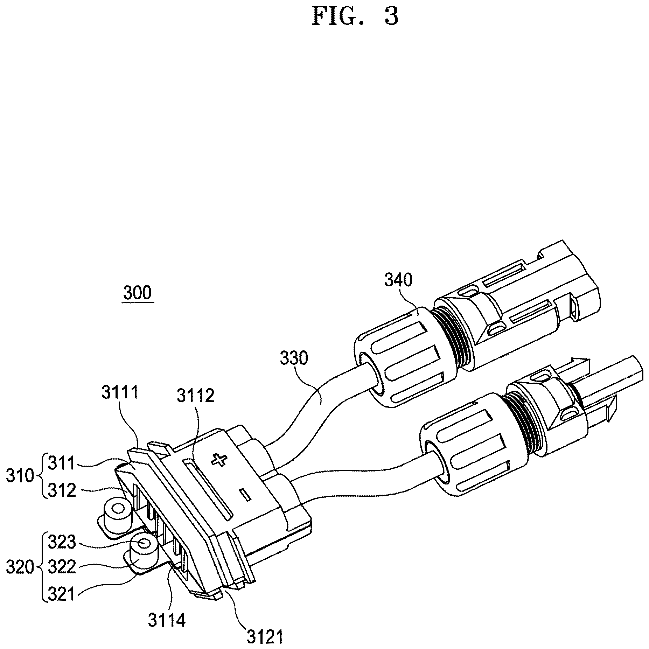

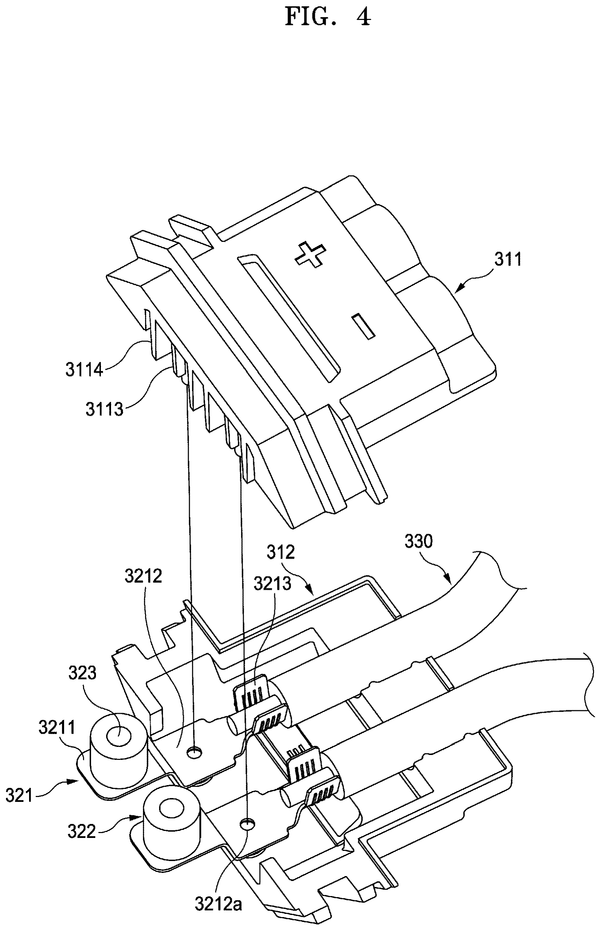

FIG. 3 is a view illustrating the first connector 300 of FIG. 1. FIG. 4 is an exploded perspective view of a portion of the first connector 300 of FIG. 3.

Referring to FIGS. 3 and 4, the first connector 300 may include a first housing 310, a first terminal 320, a cable 330, and a module connection unit 340.

The first housing 310 may form an exterior of the first connector 300 and may have a space therein. The first housing 310 may accommodate the first terminal 320 therein. The first housing 310 may correspond to a shape of a mounting portion of the case 100 for the first connector 300.

The first housing 310 may be provided to be connected to the mounting portion of the case 100 for the first connector 300. An upper surface of the first housing 310 may have a shape corresponding to the upper case 110, and a lower surface of the first housing 310 may have a shape corresponding to the lower case 120.

According to an embodiment, the first housing 310 may be formed by assembling an upper housing 311 and a lower housing 312. The first terminal 320 may be interposed between the upper housing 311 and the lower housing 312. The first terminal 320 may be connected to the cable 330 inside the first housing 310.

The upper housing 311 may form the upper surface of the first housing 310 and may include a first connector protrusion 3111, a first insert groove 3112, a support pin 3113, and a guide piece 3114.

An outer surface of the upper housing 311 may protrude to form the first connector protrusion 3111. The first connector protrusion 3111 may be assembled in contact with the upper case 110.

A portion of the outer surface of the upper housing 311 may be recessed to for the first insert groove 3112. The first insert groove 3112 may be assembled with the first fitting piece 113 described above with reference to FIG. 2.

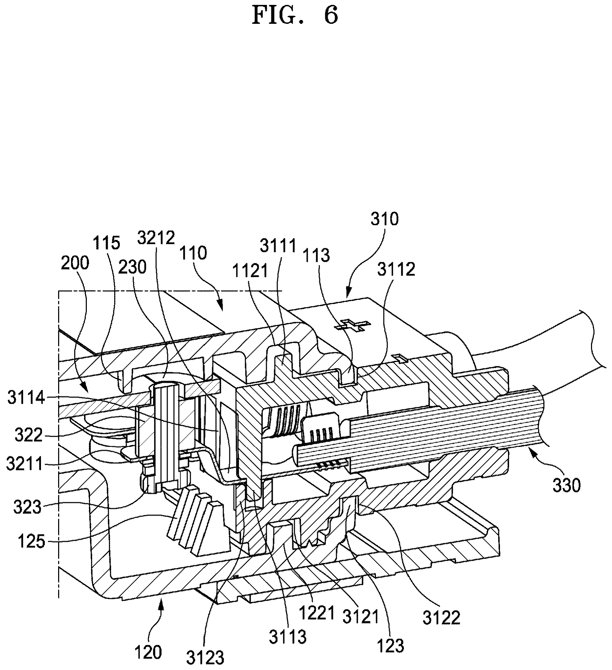

The support pin 3113 may be positioned on a lower surface of the upper housing 311 and formed in a pin shape that protrudes downward. The support pin 3113 may fix the first terminal 320 in an internal space of the first housing 310. Referring to FIG. 6, the support pin 3113 may pass through a portion of the first terminal 320 to be fastened to one side of the lower housing 312.

The guide piece 3114 may be disposed on the lower surface of the upper housing 311 and provided in a plate shape that protrudes downward. The guide piece 3114 may extend to the lower housing 312 to be connected to the lower housing 312.

The guide piece 3114 may be in contact with the first terminal 320 in the internal space of the first housing 310 to support the first terminal 320. As shown in FIGS. 3 and 4, the guide piece 3114 may be disposed on each of opposite side surfaces of the first terminal 320. Thus, a position of the first terminal 320 may be aligned, thereby preventing the first terminal 320 from being shaken or separated in a width direction.

The lower housing 312 may include a first connector groove 3121.

A portion of an outer surface of the lower housing 312 may be recessed to form the first connector groove 3121. The first connector groove 3121 may be assembled in contact with the lower case 120.

The first terminal 320 may be electrically connected to the circuit board 200. The first terminal 320 may be made of a conductive material to transmit power to the circuit board 200. Specifically, the first terminal 320 may receive DC power and may transmit the received DC power to the circuit board 200.

According to an embodiment, the first terminal 320 may be provided in a shape traversing the interior of the first housing 310. The first terminal 320 may have one side installed inside the first housing 310 and the other side connected to the circuit board 200. The first terminal 320 may be disposed inside the first housing 310, and a portion thereof may extend outward from the first housing 310.

The first terminal 320 may include a first terminal tab 321, a connection tube 322, and a fixing member 323. The first terminal tab 321 may be connected to the circuit board 200 through the connection tube 322 and the fixing member 323.

The first terminal tab 321 may be provided in a shape extending from the inside of the case 100 toward the circuit board 200. The first terminal tab 321 may be provided as a member formed by performing processing such as punching or bending on a conductive metal plate.

The first terminal tab 321 may be provided to have a certain step difference. The first terminal tab 321 may form a connection portion with each of the first housing 310, the circuit board 200, and the cable 330.

Specifically, referring to FIG. 4, the first terminal tab 321 may have an integral body, but may include a first step 3211, a second step 3212, and a connection tab 3213.

The first step 3211 may be positioned outside the first housing 310, and the connection tube 322 and the fixing member 323 may be mounted thereon. The first step 3211 may be electrically connected to the circuit board 200 through the connection tube 322 and the fixing member 323.

The first step 3211 may be bent in a direction toward the circuit board 200 to form a certain step difference from the second step 3212. Accordingly, the first step 3211 may stably generate a fastening force with the circuit board 200 even when a length of the connection tube 322 or the fixing member 323 is short.

The second step 3212 may be positioned inside the first housing 310 and fixed to the lower housing 312. The second step 3212 may have a pin through-hole 3123a. The support pin 3113 of the upper housing 311 may pass through the pin through-hole 3123a to fix a position of the second step 3212.

The connection tab 3213 may be connected to the cable 330. A portion of the connection tab 3213 which is in contact with a conducting wire of the cable 330 may spread in a V shape. The spread portion of the connection tab 3213 may be pressed to be connected to the conducting wire of the cable 330.

The connection tube 322 may be interposed between the first terminal tab 321 and the circuit board 200. The connection tube 322 may be provided in a tube shape having a preset length. For example, the connection tube 322 may be provided as a screw connection member having threads formed therein.

In an embodiment, the connection tube 322 may be made of a material having certain compressibility or elasticity and may have a strong coupling force as a shape thereof is deformed according to a fastening force of the fixing member 323.

The fixing member 323 may fix the first terminal tab 321 to the circuit board 200. The fixing member 323 may pass through the first terminal tab 321 and the connection tube 322 to be connected to the circuit board 200.

In an embodiment, the fixing member 323 may be made of a conductive material to electrically connect the first terminal tab 321 to the circuit board 200. The fixing member 323 may be provided as a typical part for connecting a conductive material, and for example, the fixing member 323 may be provided as a screw having threads, a pin, or the like. The cable 330 may be provided as a cable to which DC power is input. One side of the cable 330 may be connected to the first terminal 320, and the other side thereof may extend to the outside. The cable 330 may be connected to the first terminal tab 321 inside the first housing 310.

The module connection unit 340 may be connected to a power generation module that provides DC power. For example, the module connection unit 340 may be provided as an MC4 connector that is connected to a solar cell module.

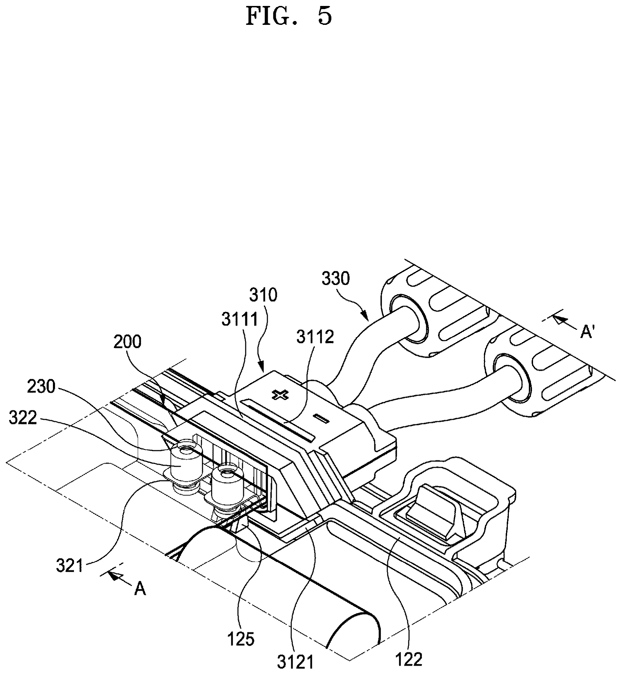

FIG. 5 is a view for describing assembly between the first connector 300 and the case 100. FIG. 6 is a partial cross-sectional view of the microinverter viewed in an A-A' direction of FIG. 5.

Specifically, FIG. 5 is a view illustrating the inside of the case 100 when the first connector 300 is mounted on the case 100. In this case, the upper case 110 is omitted to describe a connection between the first connector 300 and the circuit board 200.

Referring to FIGS. 3 to 6, when the first connector 300 is mounted on the case 100, a portion of the first housing 310 may be inserted into the case 100.

According to an embodiment, the case 100 may include a first mount portion which includes a first mount groove 1121 and a first mount protrusion 1221 to provide a space in which the first connector 300 is mounted. The first mount portion may define a position at which the first connector 300 is mounted on the case 100.

The first mount groove 1121 may be formed in a lower surface of the upper case 110. The first mount groove 1121 may be formed in a shape extending from the joint groove 112. The first mount groove 1121 may be provided as a portion of the joint groove 112 in which the first connector 300 is seated.

The first mount protrusion 1221 may be disposed on an upper surface of the lower case 120. The first mount protrusion 1221 may be formed in a shape extending from the base protrusion 122. The first mount protrusion 1221 may be provided as a portion of the base protrusion 122 on which the first connector 300 is mounted.

When the first connector 300 is mounted on the case 100, the first connector protrusion 3111 of the first housing 310 may be inserted into the first mount groove 1121 of the upper case 110. In this case, the first fitting piece 113 may be inserted into the first insert groove 3112, which is formed in the upper surface of the first housing 310, from the outside of the upper case 110.

Accordingly, on a surface on which the first housing 310 is in contact with the upper case 110, the first connector protrusion 3111 and the first mount groove 1121 may be fastened to each other, and the first insert groove 3112 and the first fitting piece 113 may be fastened to each other so that a fastening force may be generated doubly.

When the first connector 300 is mounted on the case 100, the first mount protrusion 1221 of the lower case 120 may be inserted into the first connector groove 3121 of the first housing 310.

According to an embodiment, the lower housing 312 may further include a third insert groove 3122. A portion of the outer surface of the lower housing 312 may be recessed to form the third insert groove 3122, and the third insert groove 3122 may be assembled in contact with the lower case 120. In this case, the third fitting piece 123 may be inserted into the third insert groove 3122, which is formed in the lower surface of the first housing 310, from the outside of the lower case 12.

Accordingly, on a surface on which the first housing 310 is in contact with the lower case 120, the first connector groove 3121 and the first mount protrusion 1221 may be fastened to each other, and the third insert groove 3122 and the third fitting piece 123 may be fastened to each other so that a fastening force may be generated doubly.

As an optional embodiment, the lower case 120 may further include a support block 125. The support block 125 may be positioned adjacent to the first mount protrusion 1221 and may support the first housing 310 inserted into the case 100.

When the first connector 300 is mounted on the case 100, the first housing 310 may be fastened to the circuit board 200 by the first terminal 320.

The first housing 310 may be connected to the circuit board 200 by the first terminal 320. The first housing 310 may be assembled with the first terminal 320, and the first terminal 320 may be assembled to the circuit board 200 so that a fastening force may be generated.

The support pin 3113 and a pin insert groove 3123 may be provided inside the first housing 310. By assembling the support pin 3113 and the pin insert groove 3123, a fastening force between an upper portion and a lower portion of the first housing 310 may be generated. The support pin 3113 may pass through the second step 3212 of the first terminal tab, and an end portion of the support pin 3113 may be accommodated in the pin insert groove 3123, thereby fastening the support pin 3113.

The connection tube 322 and the fixing member 323 which connect the first step 3211 and the circuit board 200 may be provided outside the first housing 310. The fixing member 323 may pass through the first step 3211 of the first terminal tab 321 to be inserted into the connection tube 322, and an end portion of the fixing member 323 may be connected to the first connection hole 230. In this case, an alignment protrusion 115 of the upper case 110 may be installed outside the end portion of the fixing member 323 so that the fixing member 323 may stably fix the circuit board 200 when fixing the circuit board 200, and a contact area may be widened to secure structural stability.

That is, the first terminal 320 may be fixed to the first housing 310 by fastening the support pin 3113 and the pin insert groove 3123, and the first terminal 320 may be fixed to the circuit board 200 by fastening the fixing member 323 and the first connection hole 230. Accordingly, the first housing 310 and the circuit board 200 may each be coupled to the first terminal 320 so that a fastening force may be generated.

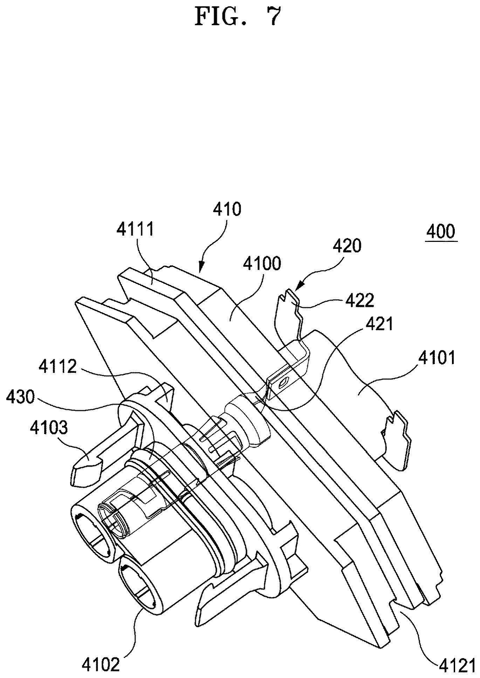

FIG. 7 is a view illustrating the second connector 400 of FIG. 1.

Referring to FIG. 7, the second connector 400 may include a second housing 410, a second terminal 420, and an O-ring 430.

The second housing 410 may form an exterior of the second connector 400 and may have a space therein. The second housing 410 may accommodate the second terminal 420 therein. The second housing 410 may correspond to a shape of a mounting portion of the case 100 for the second connector 400.

According to an embodiment, the second housing 410 may include a second housing body 4100, an insertion portion 4101, and a socket portion 4102.

The insertion portion 4101 may be provided to be inserted into the case 100. The insertion portion 4101 may be formed to extend from the second housing body 4100 toward the inside of the case 100. The insertion portion 4101 may be inserted into the case 100.

The socket portion 4102 may be provided to be connected to an external cable (not shown). The socket portion 4102 may be formed to extend from the second housing body 4100 toward the outside of the case 100. An AC output cable may be connected to the socket portion 4102.

As an optional embodiment, plug hooks 4103 may be positioned at both sides of the socket portion 4102. When a plug is inserted into the socket portion 4102, the plug hooks 4103 may come into contact with both side surfaces of the plug to assist in connection with the socket portion 4102 and stably fix a position of the plug.

A second connector protrusion 4111 may be formed on an upper surface of the second housing 410, and a fourth connector groove 4121 may be formed in a lower surface thereof.

A portion of the upper surface of the second housing 410 may protrude to form the second connector protrusion 4111. The second connector protrusion 4111 may be assembled in contact with the upper case 110.

A portion of the bottom surface of the second housing 410 may be recessed to form the fourth connector groove 4121. The fourth connector groove 4121 may be assembled in contact with the lower case 120.

A second insert groove 4112 may be formed in a connection portion between the second housing body 4100 and the socket portion 4102 and may be formed in a groove shape that is recessed upward. The second insert groove 4112 may be assembled with the second fitting piece 114 described above with reference to FIG. 2.

The second terminal 420 may be electrically connected to the circuit board 200. The second terminal 420 may be made of a conductive material and provided to receive power from the circuit board 200. Specifically, the second terminal 420 outputs AC power and may transmit the AC power to an external power system.

According to an embodiment, the second terminal 420 may be provided in a shape traversing the interior of the second housing 410. The second terminal 420 may have one side installed inside the second housing 410 and the other side connected to the circuit board 200.

According to an embodiment, the second terminal 420 may include a second terminal body 421 and a second terminal tab 422.

The second terminal body 421 may be provided as a member formed by performing processing such as punching or bending on a conductive metal plate. The second terminal body 421 may be provided in a tubular shape extending from the socket portion 4102 to the insertion portion 4101. The second terminal body 421 may be connected to the second terminal tab 422 inside the insertion portion 4101.

The terminal tab 422 may be provided as a member formed by performing processing such as punching or bending on a conductive metal plate. The second terminal tab 422 may extend from the inside to the outside of the insertion portion 4101. The second terminal tab 422 may be interposed between the second terminal body 421 and the circuit board 200. The second terminal tab 422 may have one side connected to the second terminal body 421 and the other side connected to the circuit board 200.

The second terminal body 421 may be electrically connected to the circuit board 200 through the second terminal tab 422.

The O-ring 430 may be fitted onto the socket portion 4102. When a plug of a cable is inserted into the socket portion 4102, the O-ring 430 may allow the plug to be inserted to a preset position of the socket portion 4102 and may stably fix a position of the plug.

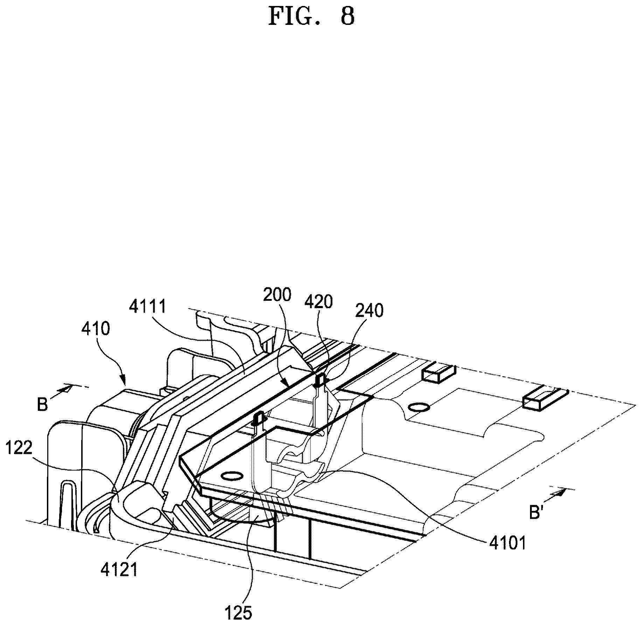

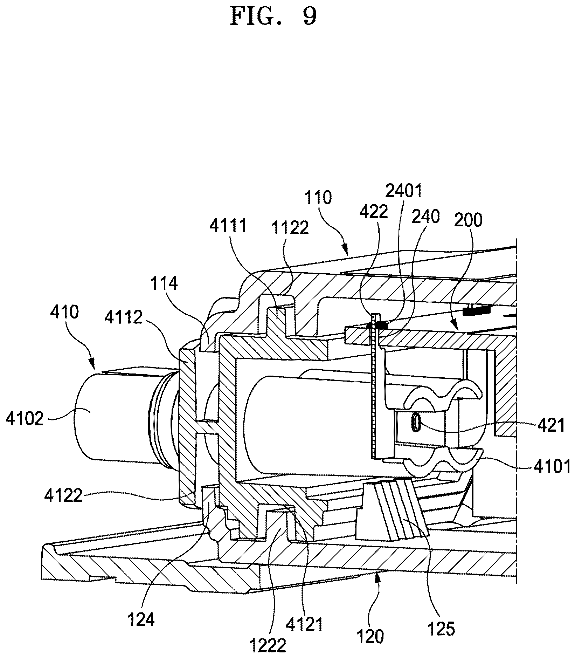

FIG. 8 is a drawing for describing assembly of the second connector 400 and the case 100. FIG. 9 is a partial cross-sectional view of the microinverter viewed in a B-B' direction of FIG. 8.

Specifically, FIG. 8 is a view illustrating the inside of the case 100 when the second connector 400 is mounted in the case 100. In this case, the upper case 110 is omitted to describe a connection between the second connector 400 and the circuit board 200.

Referring to FIGS. 7 to 9, when the second connector 400 is mounted in the case 100, a portion of the second housing 410 may be inserted into the case 100.

Specifically, the second connector 400 may be assembled by arranging the insertion portion 4101 to be inserted into the case 100 and interposing the second housing body 4100 between the upper case 110 and the lower case 120.

According to an embodiment, the case 100 may include a second mount portion which is a space in which the second connector 400 is mounted and includes a second mount groove 1122 and a second mount protrusion 1222. The second mount portion may define a position at which the second connector 400 is mounted in the case 100.

The second mount groove 1122 may be formed in the lower surface of the upper case 110. The second mount groove 1122 may be formed in a shape extending from the joint groove 112. The second mount groove 1122 may be provided as a portion of the joint groove 112 in which the second connector 400 is seated.

The second mount protrusion 1222 may be disposed on an upper surface of the lower case 120. The second mount protrusion 1222 may be formed in a shape extending from the base protrusion 122. The second mount protrusion 1222 may be provided as a portion of the base protrusion 122 on which the second connector 400 is mounted.

When the second connector 400 is mounted in the case 100, the second connector protrusion 4111 of the second housing 410 may be inserted into the second mount groove 1122 of the upper case 110.

In this case, the second fitting piece 114 may be inserted into the second insert groove 4112, which is formed in the upper surface of the second housing 410, from the outside of the upper case 110.

Accordingly, on a surface on which the second housing 410 is in contact with the upper case 110, the second connector protrusion 4111 and the second mount groove 1122 may be fastened to each other, and the second insert groove 4112 and the second fitting piece 114 may be fastened to each other so that a fastening force may be generated doubly.

When the second connector 400 is mounted in the case 100, the second mount protrusion 1222 of the lower case 120 may be inserted into the second connector groove 4121 of the second housing 410.

According to an embodiment, the second housing 410 may further include a fourth insert groove 4122. A connection portion between the second housing body 4100 and the socket portion 4102 may be recessed downward to form the fourth insert groove 4122.

In this case, the fourth fitting piece 124 may be inserted into the fourth insert groove 4122, which is formed in the lower surface of the second housing 410, from the outside of the lower case 120.

Accordingly, on a surface on which the second housing 410 is in contact with the lower case 120, the fourth connector groove 4121 and the second mount protrusion 1222 may be fastened to each other, and the fourth insert groove 4122 and the fourth fitting piece 124 may be fastened to each other so that a fastening force may be generated doubly.

As an optional embodiment, the lower case 120 may further include a support block 125. The support block 125 may be positioned adjacent to the second mount protrusion 1222 and may support the second housing 410 inserted inside the case 100.

When the second connector 400 is mounted in the case 100, the second housing 410 may be connected to the circuit board 200 by the second terminal 420.

Inside the second housing 410, the second terminal body 421 may be disposed, and the second terminal tab 422 may be connected thereto. The second terminal body 421 and the second terminal tab 422 have structures that may be assembled with each other or may be connected by pressing a contact surface.

The second terminal tab 422 may extend from the inside to the outside of the second housing 410. Outside the second housing 410, the second terminal tab 422 may be connected to the second connection hole 240. An end portion of the second terminal tab 422 may be inserted into the second connection hole 240. In this case, connection portion of the second terminal tab 422 and the second connection hole 240 may be connected using a bonding method such as soldering (wave soldering).

In summary of the above-described contents, in the microinverter 10 according to an embodiment of the present disclosure, b separately connecting each of the first connector 300 and the second connector 400 to the circuit board 200, an internal structure of the device may be simplified, thereby improving a degree of freedom in inverter structural design and obtaining an advantage in miniaturizing a device.

In addition, in the microinverter 10, the first connector 300 and the second connector 400 may be connected directly to the circuit board 200 to form a sturdy assembly structure so that power conversion performance may be stably operated.

The present disclosure has been described with reference to embodiments shown in the accompanying drawings, but this is merely illustrative, and those skilled in the art will understand that various modifications and other equivalent embodiments are possible therefrom. Therefore, the true scope of protection of the present disclosure should be determined only by the appended claims.

## Claims

1. A microinverter comprising: a case having an internal space;
a circuit board disposed inside the case;
a first connector which is supported by the case and of which a first terminal is connected directly to one side of the circuit board; and
a second connector which is supported by the case to be spaced apart from the first connector and of which a second terminal is connected directly to another side of the circuit board.

2. The microinverter of claim 1, wherein the first terminal comprises:
a first terminal tab having one end portion connected to a cable;
a connection tube disposed between another end portion of the first terminal tab and the circuit board; and
a fixing member which passes through the connection tube to connect the first terminal tab to the circuit board.

3. The microinverter of claim 2, wherein the first connector comprises:
guide pieces configured to support both side surfaces of the first terminal tab;
a support pin which passes through the first terminal tab; and
a pin insert groove which supports one surface of the first terminal tab and accommodates the support pin.

4. The microinverter of claim 1, wherein the case comprises a first mount portion in which the first connector is mounted and which comprises a first mount groove and a first mount protrusion, and the first connector comprises a first housing comprising a first connector protrusion inserted into the first mount groove and a first connector groove into which the first mount protrusion is inserted.

5. The microinverter of claim 4, wherein the first housing further comprises a first insert groove into which a first fitting piece of the case is inserted.

6. The microinverter of claim 1, wherein the second terminal comprises a second terminal tab having an end portion inserted into a connection hole of the circuit board.

7. The microinverter of claim 1, wherein the case comprises a
second mount portion in which the second connector is mounted and which comprises a second mount groove and a second mount protrusion, and
the second connector comprises a second housing comprising a second connector protrusion inserted into the second mount groove and a second connector groove into which the second mount protrusion is inserted.

8. The microinverter of claim 7, wherein the second housing further comprises a second insert groove into which a second fitting piece of the case is inserted.

9. The microinverter of claim 1, wherein the case comprises a support block which protrudes inward and supports the first connector and the second connector.
